# EUROPÄISCHE PATENTANMELDUNG

(11) **EP 2 793 538 A1**
(43) Veröffentlichungstag der Anmeldung: **22.10.2014**
(21) Anmeldenummer: 14161408.1
(22) Anmeldetag: 25.03.2014
(51) Int. Cl.: H05K 3/28, H05K 5/06, B60R 16/023, H05K 1/02

(54) **Elektronische Baugruppe und Verfahren zur Herstellung der elektronischen Baugruppe**

(30) Priorität: 16.04.2013 DE 102013206852
(71) Anmelder: ROBERT BOSCH GMBH, 70442 Stuttgart (DE)
(72) Erfinder: Guyenot, Michael, 71638 Ludwigsburg (DE); Fischer, Marc, 73262 Reichenbach (DE)

(57) **Zusammenfassung**

Die vorliegende Erfindung betrifft eine elektronische Baugruppe (1), vorzugsweise ausgebildet als Steuergerät, umfassend eine Leiterplatte (2), zumindest ein auf der Leiterplatte (2) angeordnetes elektronisches Bauelement (3), eine die Leiterplatte (2) und das zumindest eine Bauelement (3) abdeckende Schutzlackschicht (4), und eine auf der Leiterplatte (2) angeordnete Entlastungsstruktur (5) mit zumindest einem Steg (6), wobei zwischen Anteilen des einen Steges (6) und/oder zwischen benachbarten Stegen (6) Freiräume (7) verbleiben, und wobei die Schutzlackschicht (4) lediglich in den Freiräumen (7) angeordnet ist, oder wobei die Schutzlackschicht (4) in den Freiräumen (7) und auf der Entlastungsstruktur (5) angeordnet ist.

## Beschreibung

### Stand der Technik

Die vorliegende Erfindung betrifft eine elektronische Baugruppe, die insbesondere als Steuergerät ausgebildet ist. Des Weiteren betrifft die Erfindung eine mechanische Vorrichtung, umfassend die elektronische Baugruppe und ein Verfahren zur Herstellung der elektronischen Baugruppe.

Bei vorbekannten Steuergeräten werden häufig die elektronischen Bauelemente und die Leiterplatte lackiert. Diese Schutzlackierung soll zum Beispiel bei Motor- und Airbagsteuergeräten bei einer eventuellen Betauung der Leiterplatte oder der elektronischen Bauelemente mit einer Flüssigkeit vor Kurzschlüssen zwischen unterschiedlichen Potentialen schützen. Je nach thermischer und mechanischer Belastung der elektronischen Baugruppe kommt es dabei zu Schäden in der Schutzlackierung.

### Offenbarung der Erfindung

Die erfindungsgemäße elektronische Baugruppe mit den Merkmalen des Anspruchs 1 ermöglicht es, die Schutzlackschicht mittels einer Entlastungsstruktur zumindest teilweise von der Leiterplatte zu trennen oder die Schutzlackschicht in einzelne kleine Abschnitte zu unterteilen. Die Entlastungsstruktur hat die Eigenschaft, dass sie die Schutzlackschicht gezielt unterbricht bzw. schwächt, ohne jedoch die Schutzfunktion zu mindern. Dadurch wird die Schutzlackschicht möglichst spannungsfrei mit der Leiterplatte bzw. mit elektronischen Bauelementen auf der Leiterplatte verbunden. Durch mechanische oder thermische Einflüsse treten in der Leiterplatte Spannungen auf. Aufgrund der erfindungsgemäß verwendeten Entlastungsstruktur werden diese Spannungen nicht unmittelbar in die Schutzlackschicht weitergegeben. Dadurch werden Risse in der Schutzlackschicht vermieden und die Schutzlackschicht kann einen ausreichenden Schutz, insbesondere vor Eindringen von Flüssigkeiten, darstellen. All diese Vorteile werden erreicht durch eine elektronische Baugruppe, vorzugsweise ausgebildet als Steuergerät, umfassend eine Leiterplatte und zumindest ein auf der Leiterplatte angeordnetes elektronisches Bauelement. Die Leiterplatte ist insbesondere aus einem organischen Substrat gebildet. Des Weiteren umfasst die elektronische Baugruppe eine Schutzlackschicht, die die Leiterplatte und das zumindest eine Bauelement auf der Leiterplatte abdeckt. Ferner ist eine Entlastungsstruktur auf der Leiterplatte vorgesehen. Die Entlastungsstruktur wird durch zumindest einen Steg gebildet. Der Steg verläuft auf der Leiterplatte gerade und/oder gebogen. So können beispielsweise Anteile des Steges gerade verlaufen und andere Anteile des Steges gebogen verlaufen. Der eine Steg und/oder die mehrere Stege sind so angeordnet, dass zwischen den Stegen Freiräume verbleiben. Beispielsweise ein einziger mäandernder Steg kann zwischen seinen einzelnen Bögen solche Freiräume definieren. Andererseits können auch mehrere Stege so angeordnet werden, dass zwischen den Stegen Freiräume verbleiben. Die elektronischen Bauelemente auf der Leiterplatte sind insbesondere in diesen Freiräumen angeordnet. Die Schutzlackschicht kann auf zweierlei Arten aufgetragen sein: In der ersten Variante befindet sich die Schutzlackschicht lediglich in den Freiräumen. Dementsprechend werden die Freiräume separat mit dem Schutzlack besprüht. Die Schutzlackschicht ist hierbei gebildet aus einzelnen Bereichen, die durch die Entlastungsstruktur voneinander getrennt sind. Gemäß der zweiten Variante wird eine gemeinsame Schutzlackschicht aufgetragen, die sich über die Freiräume und über die Stege der Entlastungsstruktur erstreckt. Die zweite Variante ist einfacher herstellbar, da hier die Schutzlackschicht in einem Zug aufgesprüht werden kann. Es können auch beide Varianten an einer Leiterplatte angewendet werden.

Die Unteransprüche zeigen bevorzugte Weiterbildungen der Erfindung.

Insbesondere ist vorgesehen, bei der oben genannten zweiten Variante, dass die Schutzlackschicht eine durchgehende Schicht auf der Leiterplatte und der Entlastungsstruktur darstellt. Die Entlastungsstruktur beabstandet dabei die Schutzlackschicht zumindest stellenweise von der Leiterplatte. Durch die Verwendung der Entlastungsstruktur erhält die Schutzlackschicht eine dreidimensionale Gestalt und kann infolgedessen besser Spannungen absorbieren.

Die Freiräume weisen bevorzugt eine lichte Weite von 1 mm bis 30 mm, vorzugsweise von 5 mm bis 25 mm, auf. Dabei können die mehreren Freiräume einer elektronischen Baugruppe durchaus unterschiedliche lichte Weiten aufweisen. Die tatsächliche Größe der Freiräume ist durch die verwendeten elektronischen Bauelemente auf der Leiterplatte vorgegeben, so dass bevorzugt die Freiräume ausreichen, um darin die elektronischen Bauelemente anzuordnen.

Die Entlastungsstruktur ist bevorzugt als Netz ausgebildet. In Draufsicht auf die Leiterplatte stellt dieses Netz insbesondere ein Rauten- oder Wabenmuster dar. Die Maschenweite des Netzes entspricht dabei der oben genannten lichten Weite.

Die Entlastungsstruktur weist bevorzugt eine erste Höhe auf. Das höchste von der Schutzlackschicht abgedeckte Bauelement weist bevorzugt eine zweite Höhe auf. Die beiden Höhen sind senkrecht zur Leiterplatte definiert. Die erste Höhe beträgt insbesondere 20% bis 200%, vorzugsweise 50% bis 200%, besonders vorzugsweise 90% bis 150%, der zweiten Höhe. Dadurch ist sichergestellt, dass die Höhe der Entlastungsstruktur in etwa an die Höhe der verwendeten elektronischen Bauelemente angepasst ist.

Für die Entlastungsstruktur wird vorzugsweise ein flexibleres Material gewählt, als für die Schutzlackschicht. Insbesondere ist vorgesehen, dass für die Schutzlackschicht ein Epoxid-Lack verwendet wird. Die Entlastungsstruktur besteht vorzugsweise aus Silikon oder Acryl.

Die Erfindung umfasst des Weiteren eine mechanische Vorrichtung, vorzugsweise ausgebildet als Getriebe in einem Fahrzeug. Diese mechanische Vorrichtung umfasst ein Gehäuse, welches zur Aufnahme einer Schmiermittelfüllung ausgebildet ist. In dem Gehäuse befinden sich insbesondere bewegliche Teile, die mit dem Schmiermittel geschmiert werden. Des Weiteren ist in dem Gehäuse eine der soeben beschriebenen elektronischen Baugruppen angeordnet. Die elektronische Baugruppe umfasst keine eigene Abdeckung im Gehäuse. Vielmehr ist die Schutzlackschicht direkt dem Schmiermittel ausgesetzt. Hier ist es besonders wichtig, dass die Schutzlackschicht auch bei entsprechender mechanischer oder thermischer Beanspruchung dicht hält. Deshalb wird hier bevorzugt die Entlastungsstruktur eingesetzt.

Insbesondere ist dabei die elektronische Baugruppe als Getriebesteuergerät ausgebildet. Die Leiterplatte ist insbesondere durch ein organisches Substrat gebildet. Das Dichthalten der Schutzlackschicht ist hier besonders wichtig, da ansonsten das Öl und elektrisch leitfähige Partikel in direkten Kontakt mit den Leiterbahnen auf der Leiterplatte geraten könnten. Insbesondere Additive im Öl (zum Beispiel Schwefel oder Schwefelverbindungen), wie auch das Grundöl selbst, reagieren mit dem Kupfer und Kupferverbindungen auf der Leiterplatte, wodurch Kupfer in Lösung gehen würde. Infolgedessen könnte über die Lebensdauer eine Unterbrechung der Leiterbahnen oder Ankontaktierungen entstehen. Ferner könnten elektrisch leitfähige Ablagerungen durch ausgefälltes Kupfer oder ausgefällte leitfähige Partikel entstehen. All dies wird verhindert, da aufgrund der Entlastungsstruktur die Schutzlackschicht dicht bleibt.

Die Entlastungsstruktur besteht insbesondere aus einem elektrisch nicht leitfähigen Material. Vorzugsweise besteht die Entlastungsstruktur lediglich aus dem einen Steg oder den mehreren Stegen. Die Entlastungsstruktur erfüllt dabei bevorzugt lediglich die Aufgabe, die Schutzlackschicht gegenüber der Leiterplatte spannungsfrei zu positionieren.

Die Erfindung umfasst des Weiteren ein Verfahren zur Herstellung der elektronischen Baugruppe. Das Verfahren umfasst die folgenden Schritte: (i) Bereitstellen der Leiterplatte mit zumindest einem auf der Leiterplatte angeordneten elektronischen Bauelement, (ii) Aufbringen einer Entlastungsstruktur auf die Leiterplatte, (iii) Aufbringen einer die Leiterplatte und das zumindest eine Bauelement abdeckenden Schutzlackschicht. Die Entlastungsstruktur umfasst zumindest einen auf der Leiterplatte gerade oder gebogen verlaufenden Steg, wobei zwischen Anteilen des einen Steges oder zwischen benachbarten Stegen Freiräume verbleiben. Die Schutzlackschicht wird gemäß der ersten Variante lediglich in die Freiräume aufgebracht. Gemäß der zweiten Variante wird die Schutzlackschicht über die gesamte Anordnung, also in die Freiräume und auf die Entlastungsstruktur, aufgebracht.

Die im Rahmen der erfindungsgemäßen elektronischen Baugruppe beschriebenen Unteransprüche und vorteilhaften Ausgestaltungen finden entsprechend vorteilhafte Anwendung auf das erfindungsgemäße Verfahren.

Insbesondere ist vorgesehen, dass die Entlastungsstruktur als flüssiges oder zähflüssiges Material auf die Leiterbahn aufgetragen wird. Insbesondere wird dieses Material dispensiert. Auf der Leiterplatte härtet das Material dann zumindest teilweise aus und bildet so die Entlastungsstruktur.

### Kurze Beschreibung der Zeichnungen

Nachfolgend wird ein Ausführungsbeispiel der Erfindung unter Bezugnahme auf die begleitende Zeichnung im Detail beschrieben. Dabei zeigen:
- Figur 1: eine erfindungsgemäße elektronische Baugruppe gemäß einem Ausführungsbeispiel vor dem Aufbringen einer Schutzlackschicht, und
- Figur 2: die erfindungsgemäße elektronische Baugruppe gemäß dem Ausführungsbeispiel mit aufgebrachter Schutzlackschicht.

### Ausführungsform der Erfindung

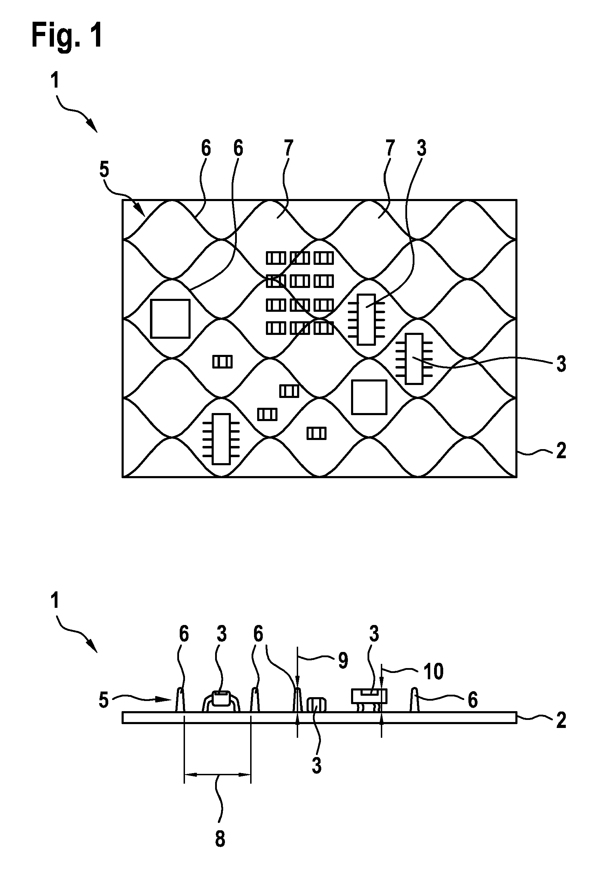

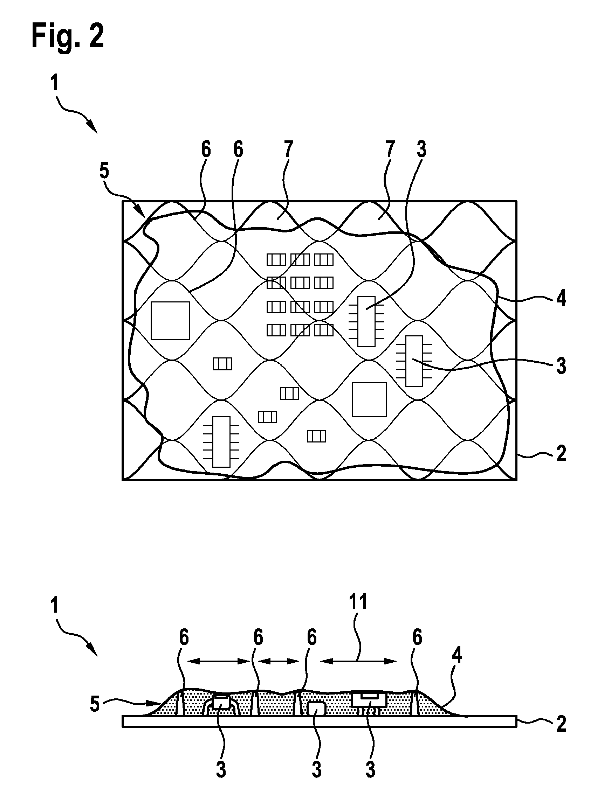

Figuren 1 und 2 zeigen eine elektronische Baugruppe 1 in zwei unterschiedlichen Zuständen während der Herstellung. In Figur 1 wurde eine Schutzlackschicht 4 noch nicht aufgetragen. Figur 2 zeigt den Zustand, in dem die Schutzlackschicht 4 aufgetragen ist. Die beiden Figuren zeigen jeweils oben eine Draufsicht auf die elektronische Baugruppe 1 und darunter eine geschnittene Seitenansicht.

Die elektronische Baugruppe 1 umfasst eine Leiterplatte 2 und mehrere auf der Leiterplatte 2 angeordnete elektronische Bauelemente 3. Die elektronische Baugruppe 1 ist insbesondere als Steuergerät ausgebildet und wird vorzugsweise in einem Kraftfahrzeug verwendet.

Die elektronische Baugruppe 1 umfasst des Weiteren die Schutzlackschicht 4, die die Leiterplatte 2 und die elektronischen Bauelemente 3 abdeckt. Zwischen der Schutzlackschicht 4 und der Leiterplatte 2 ist eine Entlastungsstruktur 5 angeordnet.

Die Entlastungsstruktur 5 ist gebildet durch mehrere Stege 6. Die Stege 6 sind netzförmig angeordnet. Zwischen den Stegen 6 sind Freiräume 7 gebildet.

Wie insbesondere die untere Ansicht in Figur 1 zeigt, weisen die Freiräume 7 lichte Weiten 8 auf. Die lichten Weiten 8 können auch als Maschenweiten bezeichnet werden. Die lichten Weiten 8 sind etwas größer als die elektronischen Bauelemente 3, so dass die elektronischen Bauelemente 3 in den Freiräumen 7 Platz finden.

Die Stege 6 der Entlastungsstruktur 5 erstrecken sich über eine erste Höhe 9, die etwas größer ist als eine zweite Höhe 10 der größten elektronischen Bauelemente 3.

Die Entlastungsstruktur 5 besteht aus einem flexibleren Material als die Schutzlackschicht 4. Dadurch kann die Schutzlackschicht 4 die in Figur 2 mit Bezugszeichen 11 angedeutete flexible Bewegung ausführen. Infolge dieser flexiblen Bewegung 11 bleibt die Schutzlackschicht 4 intakt, selbst wenn es aufgrund thermischer oder mechanischer Einflüsse zu Spannungen in der Leiterplatte 2 kommt.

Das gezeigte Ausführungsbeispiel zeigt eine Ausdehnung der Schutzlackschicht 4 über die Freiräume 7 und über die Entlastungsstruktur 5 hinweg. Alternativ dazu ist es möglich, alle oder manche Freiräume 7 mit einer eigenen Schutzlackschicht 4 zu versehen. Diese einzelnen Schutzlackschichtabschnitte in den Freiräumen 7 sind dann durch die Stege 6 voneinander getrennt, wodurch auch eine spannungsfreie Anordnung der Schutzlackschicht 4 gegenüber der Leiterplatte 2 möglich ist.

## Patentansprüche

1. Elektronische Baugruppe (1), vorzugsweise ausgebildet als Steuergerät, umfassend
- eine Leiterplatte (2),
- zumindest ein auf der Leiterplatte (2) angeordnetes elektronisches Bauelement (3),
- eine die Leiterplatte (2) und das zumindest eine Bauelement (3) abdeckende Schutzlackschicht (4), und
- eine auf der Leiterplatte (2) angeordnete Entlastungsstruktur (5) mit zumindest einem Steg (6),
- wobei zwischen Anteilen des einen Steges (6) und/oder zwischen benachbarten Stegen (6) Freiräume (7) verbleiben, und
- wobei die Schutzlackschicht (4) lediglich in den Freiräumen (7) angeordnet ist, oder wobei die Schutzlackschicht (4) in den Freiräumen (7) und auf der Entlastungsstruktur (5) angeordnet ist.

2. Elektronische Baugruppe nach Anspruch 1, **dadurch gekennzeichnet, dass** die Schutzlackschicht (4) eine durchgehende Schicht auf der Leiterplatte (2) und der Entlastungsstruktur (5) darstellt, wobei die Entlastungsstruktur (5) die Schutzlackschicht (2) zumindest stellenweise von der Leiterplatte (2) beabstandet.

3. Elektronische Baugruppe nach einem der vorhergehenden Ansprüche, **dadurch gekennzeichnet, dass** die Freiräume (7) lichte Weiten (8) von 1 mm bis 30mm, vorzugsweise von 5mm bis 25mm, aufweisen.

4. Elektronische Baugruppe nach einem der vorhergehenden Ansprüche, **dadurch gekennzeichnet, dass** die Entlastungsstruktur (5) als Netz ausgebildet ist.

5. Elektronische Baugruppe nach einem der vorhergehenden Ansprüche, **dadurch gekennzeichnet, dass** die Entlastungsstruktur (5) eine erste Höhe (9) aufweist, und das höchste von der Schutzlackschicht (4) abgedeckte Bauelement eine zweite Höhe (10) aufweist, wobei die erste Höhe (9) 20% bis 200%, vorzugsweise 50% bis 200%, besonders vorzugsweise 90% bis 150%, der zweiten Höhe (10) beträgt.

6. Elektronische Baugruppe nach einem der vorhergehenden Ansprüche, **dadurch gekennzeichnet, dass** die Entlastungsstruktur (5) aus einem flexibleren Material als die Schutzlackschicht (4) besteht.

7. Mechanische Vorrichtung, vorzugsweise Getriebe, umfassend
- ein Gehäuse, welches zur Aufnahme einer Schmiermittelfüllung ausgebildet ist, und
- eine im Gehäuse angeordnete elektronische Baugruppe (1) nach einem der vorhergehenden Ansprüche,
- wobei die Schutzlackschicht (4) der elektronischen Baugruppe (1) direkt dem Schmiermittel im Gehäuse ausgesetzt ist.

8. Verfahren zur Herstellung einer elektronischen Baugruppe (1), vorzugsweise ausgebildet als Steuergerät, umfassend die folgenden Schritte:
- Bereitstellen einer Leiterplatte (2) mit zumindest einem auf der Leiterplatte (2) angeordneten elektronischen Bauelement (3),
- Aufbringen einer Entlastungsstruktur (5) auf die Leiterplatte (2), wobei die Entlastungsstruktur (5) zumindest einen auf der Leiterplatte (2) verlaufenden Steg (6) umfasst, und zwischen Anteilen des einen Steges (6) und/oder zwischen benachbarten Stegen (6) Freiräume (7) verbleiben, und
- Aufbringen einer die Leiterplatte (2) und das zumindest eine Bauelement (3) abdeckenden Schutzlackschicht (4),
- wobei die Schutzlackschicht (4) lediglich in die Freiräume (7) aufgebracht wird, oder wobei die Schutzlackschicht (4) in die Freiräume (7) und auf die Entlastungsstruktur (5) aufgebracht wird.

9. Verfahren nach Anspruch 8, **dadurch gekennzeichnet, dass** die Entlastungsstruktur (5) als flüssiges oder zähflüssiges Material auf die Leiterbahn (2) aufgetragen, insbesondere dispensiert, wird.
